# EUROPÄISCHE PATENTSCHRIFT

(11) **EP 1 216 558 B1**
(45) Veröffentlichungstag und Bekanntmachung des Hinweises auf die Patenterteilung: **22.12.2004**
(21) Anmeldenummer: 00943927.4
(22) Anmeldetag: 28.06.2000
(51) Int. Cl.: H04L 27/36, H03F 1/32

(54) **SENDE-EMPFANGSEINRICHTUNG MIT GESCHLOSSENER KARTESISCHER RÜCKKOPPLUNGSSHLEIFE**
TRANSMITTING-RECEIVING DEVICE COMPRISING A CLOSED CARTESIAN FEEDBACK LOOP
EMETTEUR-RECEPTEUR A BOUCLE DE RETROACTION CARTESIENNE FERMEE

(30) Priorität: 29.09.1999 DE 19946668
(43) Veröffentlichungstag der Anmeldung: 26.06.2002
(73) Patentinhaber: Rohde & Schwarz GmbH & Co. KG, 81671 München (DE)
(72) Erfinder: LIPP, Friedrich, A-5322 Hof bei Salzburg (AT)
(74) Vertreter: Körfer, Thomas, Dipl.-Phys.
(86) Internationale Anmeldenummer: PCT/EP2000/006030
(87) Internationale Veröffentlichungsnummer: WO 2001/024472

(56) Entgegenhaltungen:
- WO-A-00/25421
- WO-A-98/00908
- WO-A-99/04486
- US-A- 5 793 817
- US-A- 5 894 496

## Beschreibung

Die Erfindung betrifft eine Sendeeinrichtung mit einem Quadraturmodulator und einem Leistungsverstärker, der durch eine sogenannte kartesische Rückkopplungsschleife (cartesian feedback) mit einem Quadraturdemodulator linearisiert ist.

Eine Sendeeinrichtung nach dem Oberbegriff des Anspruchs 1 geht beispielsweise aus der EP 0 706 259 A1 hervor. Bei der aus dieser Druckschrift hervorgehenden Sendeeinrichtung wird ein Basisband-Eingangssignal über zwei Differenzverstärker einem Quadraturmodulator zugeführt, welcher eine Quadraturmodulation der Inphase-Komponente und der Quadraturphase-Komponente des komplexen Eingangssignals vornimmt. Dabei wird das Signal einem Aufwärtskonverter zugeführt, welcher das Signal vom Basisband auf die Sendefrequenz anhebt. Die Leistungsverstärkung erfolgt in einem nachfolgenden Leistungsverstärker. Zum Ausgleich der Nichtlinearität dieses Leistungsverstärkers ist eine Rückkopplungsschleife vorgesehen, die im allgemeinen cartesian feedback bezeichnet wird. In dieser Rückkopplungsschleife befindet sich zunächst ein Abwärtskonverter, um das von dem Ausgang des Leistungsverstärkers ausgekoppelte Sendesignal in das Basisband zurück zu konvertieren. Im Basisband befindet sich ein Quadraturdemodulator, der das rückgekoppelte Signal in eine rückgekoppelte Inphase-Komponente und eine rückgekoppelte Quadraturphase-Komponente zerlegt. Die rückgekoppelte Inphase-Komponente wird zusammen mit der Inphase-Komponente des Eingangssignals einem dem Quadraturmodulator vorgeschalteten ersten Differenzverstärker zugeführt. Entsprechend wird die rückgekoppelte Quadraturphase-Komponente zusammen mit der Quadraturphase-Komponente des Eingangssignals einem zweiten Differenzverstärker zugeführt. Dadurch werden die Nichtlinearitäten des Leistungsverstärkers über das rückgekoppelte Signal ausgeglichen.

In der EP 0 706 259 A1 wird noch vorgeschlagen, zum Ausgleich der Gleichspannungs-Komponenten des Quadraturmodulators einen Testbetrieb vorzusehen, bei welchem der Sendeeinrichtung kein Eingangssignal zugeführt wird. Das Ausgangssignal der beiden Differenzverstärker wird jeweils in einem Integrator integriert und jeweils einem dem Integrator nachgeschalteten Abtast- und Halteschaltung zugeführt. Die Abtast-Halteschaltung befindet sich während des Testbetriebs in dem Abtastzustand und führt einen gegengekoppelten Eingang des zugeordneten Differenzverstärkers ein solches Kompensationssignal zu, daß die Gleichspannungs-Komponenten des zugeordneten Zweigs des Quadraturmodulators kompensiert werden. Während des normalen Sendebetriebs befindet sich die Abtast- und Halteschaltung im Haltezustand und führt dem Eingang des jeweiligen Differenzverstärkers den während des Testbetriebs ermittelten Kompensationspegel zu. Ferner wird in der EP 0 706 259 A1 noch vorgeschlagen, während eines weiteren Testbetriebs, bei welchem am Ausgang des Quadraturdemodulators vorgesehene Schalter geöffnet sind, durch Erfassen des Ausgangssignals des Quadraturdemodulators in diesem Zustand bei zwei verschiedenen Eingangssignalen den Phasenversatz für einen zwischen einem lokalen Oszillator und dem Quadraturdemodulator vorgesehen Phasenschieber zu ermitteln.

Bei der Anwendung einer nach dem Prinzip des cartesian feedback arbeitenden Sendeeinrichtung im Flugfunk, insbesondere beim nach dem VDL-Standard (VHF-Digital-Link) im TDMA-Simplex-Betrieb arbeitendem digitalen Flugfunk, besteht das Problem, daß eine schnelle Umschaltung zwischen dem Sendebetrieb und dem Empfangsbetrieb nur mit Schwierigkeiten verwirklicht werden kann, da beim Umschalten vom Sendebetrieb zum Empfangsbetrieb der Leistungsverstärker und der lokale Oszillator vollständig abgeschaltet werden müssen, um eine Einstrahlung in den Empfänger zu vermeiden. Dabei wird jedoch zwangsläufig die Hochfrequenz-Rückkopplungsschleife zwischen den Ausgängen und den Kompensationseingängen der Differenzverstärker unterbrochen.

Beim Wiedereinschalten des Leistungsverstärkers und des lokalen Oszillators beim Umschalten vom Empfangsbetrieb zum Sendebetrieb muß sich die Rückkopplungsschleife deshalb wieder neu einschwingen, was zu unerwünschten Signalsprüngen bei der Sende-Empfangsumschaltung führt. Die Regelung der Rückkopplungsschleife würde während der Sendeunterbrechung auf das positive oder negative Regelungsende einregeln. Beim Wiedereinschalten käme sofort die volle Sendeleistung zum Einsatz. Der EP 0 706 259 A1 lassen sich keine Maßnahmen zur Beseitigung dieses Problems entnehmen.

Die US-A-5 793 817 offenbart eine Sendeeinrichtung mit einem kartesischen Rückkopplungsverstärker gemäß dem Oberbegriff des Anspruchs 1 bestehend aus einem Quadraturmodulator und einem Leistungsverstärker in einem Vorwärtspfad sowie einem Quadraturdemodulator und zwei Differenzverstärkern in einem Rückkopplungspfad. Diese Druckschrift hat als Aufgabe, Gleichspannungsversätze in den Mischstufen des Modulators auszugleichen, welche in einem Sendeunterbrechungsintervall unter Umgehung von Quadraturmodulator, Leistungsverstärker sowie Quadraturdemodulator gemessen und gespeichert werden, um anschließend bei Wiederaufnahme des Sendebetriebs den invertierenden Differenzverstärkereingängen als Kompensationswerte zugeschaltet zu werden.

Eine weitere Sendeeinrichtung nach dem kartesischen feedback-Verfahren ist aus der WO 00/25421 A bekannt. Dieses Dokument ist jedoch erst am 4. Mai 2000, also nach dem Prioritätstag der vorliegenden Anmeldung, veröffentlicht worden und daher für die Prüfung der erfinderischen Tätigkeit nicht relevant.

Der Erfindung liegt deshalb die Aufgabe zugrunde, eine Sendeeinrichtung mit einem Leistungsverstärker, welcher nach dem Prinzip des cartesian feedback linearisiert ist, zu schaffen, bei welcher eine schnelle Sende-Empfangsumschaltung ermöglicht ist, und ein entsprechendes Verfahren zum Umschalten dieser Sendeeinrichtung vom Sendebetrieb in einen Sendeunterbrechungsbetrieb bzw. Empfangsbetrieb anzugeben.

Die Aufgabe wird bezüglich der Sendeeinrichtung durch die kennzeichnenden Merkmale des Anspruchs 1 und bezüglich des Verfahrens durch die kennzeichnenden Merkmale des Anspruchs 9 jeweils in Verbindung mit den gattungsbildenden Merkmalen gelöst.

Der Erfindung liegt die Erkenntnis zugrunde, daß dem durch den Quadraturmodulator, den Leistungsverstärker und den Quadraturdemodulator gebildeten Hochfrequenz-Signalpfad ein weiterer direkter Signalpfad parallel geschaltet wird, über welchen unter Umgehung des Quadraturmodulators, des Leistungsverstärkers und des Quadraturdemodulators der Ausgang des Differenzverstärkers beim Umschalten von dem Sendebetrieb in den Empfangsbetrieb mit dem gegengekoppelten Eingang verbunden wird. Der Ausgang des Differenzverstärkers .ist mit seinem gegengekoppeltem Eingang deshalb jederzeit verbunden - beim Sendebetrieb über dem Hochf requenz-Signalpfad und beim Empfangsbetrieb über den direkten (Gleichstrom)-Signalpfad. Die Sende-Empfangsumschaltung erfolgt dabei vorzugsweise in der Weise, daß beim Umschalten vom Sendebetrieb in den Empfangsbetrieb zunächst der direkte (Gleichstrom)-Signalpfad geschlossen wird, bevor der Hochfrequenz-Signalpfad geöffnet wird. Beim Umschalten vom Sendebetrieb in den Empfangsbetrieb wird entsprechend umgekehrt vorgegangen. Auf diese Weise werden Signalsprünge bei der Sende- Empfangsumschaltung vermieden.

Die Ansprüche 2 bis 8 betreffen vorteilhafte Weiterbildungen der Sendeeinrichtung und der Anspruch 10 betrifft eine vorteilhafte Weiterbildung des erfindungsgemäßen Verfahrens.

Vorteilhaft sind sowohl in dem Inphase-Signalpfad als auch in dem Quadraturphase-Signalpfad jeweils zwei weitere Differenzverstärker vorgesehen, mit welchen sich Abgleichspannungen in die Signalpfade einkoppeln lassen, um sowohl den Gleichspannungsversatz (DC-offset) des Quadraturmodulators als auch den Gleichspannungsversatz (DC-offset) des Quadraturdemodulators zu kompensieren. Dadurch wird im abgeschalteten Zustand, wenn am I- und Q-Eingang kein Signal anliegt, der Spannungswert OV am Eingang und Ausgang der Differenzverstärker erreicht, wodurch die Zuschaltung des Gleichstrom-Signalpfads stoßfrei erfolgen kann.

Der Abgleich des Quadraturmodulators wird bei geschlossenem Hochfrequenz-Signalpfad vorgenommen. Der Abgleich des Quadraturdemodulators hingegen wird bei geöffnetem Hochfrequenz-Signalpfad und geschlossenem Gleichstrom-Signalpfad vorgenommen. Der. Abgleich erfolgt dabei in der Weise, daß die Ausgangsspannung an den der Kompensation dienenden Differenzverstärkern minimiert wird. Dies kann bei sehr geringem Meßaufwand und hoher Meßgeschwindigkeit erfolgen. Zusätzlich kann ein Feinabgleich des Quadraturdemodulators bei noch geschlossenem Hochfrequenz-Signalpfad erfolgen, wobei dann als Meßgröße die Ausgangsleistung. des Leistungsverstärkers bei abgeschaltetem Eingangssignal herangezogen wird, die z. B. über einen logarithmischen Detektor gemessen werden kann.

Ein vereinfachtes Ausführungsbeispiel der Erfindung wird nachfolgend unter Bezugnahme auf die Zeichnung näher beschrieben. In der Zeichnung zeigen:
- Fig. 1: ein Blockschaltbild eines Ausführungsbeispiels der erfindungsgemäßen Sendeeinrichtung;
- Fig. 2: ein Detail der in Fig. 1 dargestellten Sendeeinrichtung; und
- Fig. 3: ein schematische Darstellung der Ausgangsleistung der Sendeeinrichung als Funktion der Zeit zur Erläuterung eines bevorzugten Abgleichverfahrens.

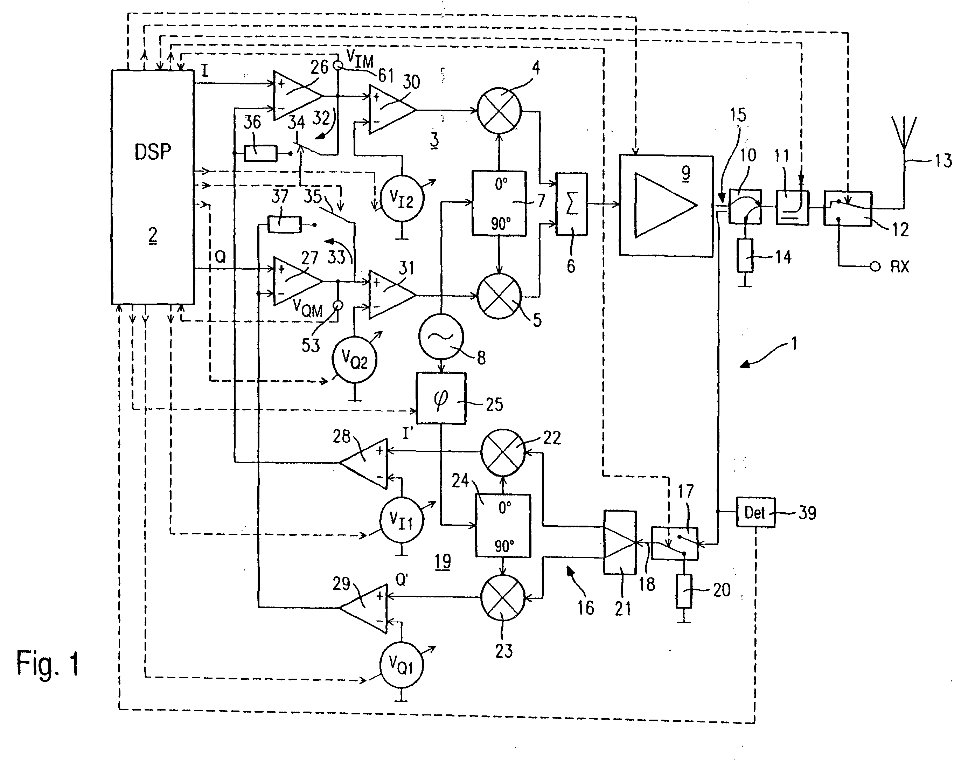

Fig. 1 zeigt ein erstes Ausführungsbeispiel der erfindungsgemäßen Sendeeinrichtung in einem prinzipiellen Blockschaltbild.

Ein digitaler Signalprozessor (DSP) 2 erzeugt ein komplexes Eingangssignal für einen Quadraturmodulator 3, der aus einem Inphase-Mischer 4, einem Quadraturphase-Mischer 5 und einem Summierer 6 sowie einem Phasenschieber 7 besteht. Das komplexe Eingangssignal besteht aus einer Inphase-Komponente I und einer Quadraturphase-Komponente Q, wobei die Inphasen-Komponente I dem Inphase-Mischer 4 und die Quadraturphase-Komponente Q dem Quadraturphase-Mischer 5 zugeführt wird. Dem Phasenschieber 7 wird das Ausgangssignal eines lokalen Oszillators 8 zugeführt, wobei der Phasenschieber 7 dieses Oszillatorsignal dem Inphase-Mischer 4 ohne Phasenverschiebung und dem Quadraturphase-Mischer 5 unter einer Phasenverschiebung von 90° zuführt.

Dem Quadraturmodulator 3 ist ein Leistungsverstärker 9 nachgeschaltet, der das quadraturmodulierte Signal entsprechend der Sendeleistung der Sendeeinrichtung 1 leistunasverstärkt und über einen Zirkulator 10. einen Leistungsdetektor 11 und einen Sende-Empfangsumschalter 12 einer Antenne 13 zuführt. Im in Fig. 1 dargestellten Ausführungsbeispiel dient der digitale Signalprozessor 2 gleichzeitig als Steuereinheit für die Sende-Empfangsumschaltung und steuert den Sende-Empfangsumschalter 12 so an, daß die Antenne 13 beim Sendebetrieb mit dem Leistungsverstärker 9 und beim Empfangsbetrieb mit einem als RX bezeichneten Empfänger verbunden ist. Um eine Rückkopplung eventuell reflektierter Sendeleistung in den Leistungsverstärker 9 zu vermeiden, dient der mit dem Abschlußwiderstand 14 verbundene Zirkulator 10.

In dem Signalpfad zwischen dem Leistungsverstärker 9 und der Antenne 13 befindet sich ein Auskoppler 15, der das Ausgangssignal des Leistungsverstärkers 9 in eine Rückkopplungsschleife 16 einkoppelt. In der Rückkopplungsschleife 16 befindet sich ein Umschalter 17, über welchen ein Eingang 18 eines Quadraturdemodulators 19 wahlweise mit dem Auskoppler 15 oder einem Abschlußwiderstand 20 verbindbar ist. Zwischen dem Auskoppler 15 und dem Umschalter 17 befindet sich ein logarithmischer Leistungsdetektor 39. Der Quadraturdemodulator 19 besteht aus einem Signalverteiler 21, der das Eingangssignal gleichmäßig auf einen Inphase-Mischer 22 und einen Quadraturphase-Mischer 23 verteilt. Ferner ist ein Phasenschieber 24 vorgesehen, dem das Ausgangssignal des lokalen Oszillators 8 über einen einstellbaren Phasenschieber 25 zugeführt wird. Der Phasenschieber 24 arbeitet wie der Phasenschieber 7 und führt dem Inphase-Mischer 22 ein nicht phasenverschobenes Oszillatorsignal und dem Quadraturphasen-Mischer 23 ein um 90° phasenverschobenes Oszillatorsignal zu, wobei das Oszillatorsignal vorher durch den Phasenverschieber 25 insgesamt um einen Phasenwinkel ϕ phasenverschoben wurde.

Am Ausgang des Inphase-Mischers 22 liegt eine rückgekoppelte Inphase-Komponente I' und am Ausgang des Quadraturphase-Mischers 23 liegt eine rückgekoppelte Quadraturphase-Komponente Q' vor. Die Inphase-Komponente I des Eingangssignals wird auf den (+)-Eingang eines ersten Differenzverstärkers 26 gegeben, während die rückgekoppelte Inphase-Komponente I' auf den (-)-Eingang der ersten Differenzverstärkers 26 gegeben wird. In entsprechender Weise wird die Quadraturphase-Komponente Q des Eingangssignals dem (+)-Eingang eines zweiten Differenzverstärkers 27 zugeführt, während die rückgekoppelte Quadraturphase-Komponente Q' dem (-)-Eingang des zweiten Differenzverstärkers 27 zugeführt wird. Durch diese, allgemein als cartesian feedback bezeichnete Rückkopplungs-Anordnung wird erreicht, daß Linearisierungsfehler des Leistungsverstärkers 9 durch den in der Rückkopplungsschleife 16 angeordneten Quadraturdemodulators 19 und die Differenzverstärker 26 und 27 kompensiert werden. Dabei ist jedoch zu beachten, daß das rückgekoppelte Signal I',Q' den Differenzverstärkern 26 und 27 mit einer Phasenverschiebung von 0° gegenüber dem Eingangssignal I,Q zugeführt wird. Die richtige Phasenlage wird durch den verstellbaren Phasenverschieber 25 eingestellt, dessen Phasenwinkel ϕ durch den digitalen Signalprozessor über ein Steuersignal veränderbar ist.

Da sowohl der Quadraturmodulator 3 als auch der Quadraturdemodulator 19 einen Gleichspannungsversatz (DC-offset) aufweisen, ist dieser Gleichspannungsversatz entsprechend zu kompensieren.

Dazu dient ein dritter Differenzverstärker 28, der zwischen dem Inphase-Mischer 22 des Quadraturdemodualators 19 und dem ersten Verstärker 26 angeordnet ist. Ein vierter Differenzverstärker 29 ist zwischen dem Quadraturphase-Mischer 23 des Quadraturdemodulators 19 und dem zweiten Differenzverstärker 27 angeordnet. Während dem (+)-Eingang des dritten Differenzverstärkers 28 die rückgekoppelte Inphase-Komponente I' zugeführt wird, wird dem (-)-Eingang des dritten Differenzverstärkers 28 eine erste Abgleichspannung V_{I1} zugeführt, so daß am Ausgang des dritten Differenzverstärkers 28 der Gleichspannungsversatz in der I'-Komponente des Quadraturdemodulators 19 kompensiert ist. In entsprechender Weise wird dem vierten Differenzverstärker 29 an dessen (+)-Eingang die rückgekoppelte Quadraturphase-Komponente Q' zugeführt; während dessen (-)-Eingang ein vierte Abgleichspannung V_{Q1} zugeführt wird.

Um den Gleichspannungsversatz des Quadraturmodulators 3 zu kompensieren, dient ein fünfter Differenzverstärker 30, dessen (+)-Eingang der Ausgang des ersten Differenzverstärkers 26 zugeführt wird, während dessen (-)-Eingang eine dritte Abgleichspannung V_{I2} zugeführt wird. Ferner ist ein sechster Differenzverstärker 31 vorgesehen, dessen Ausgang mit dem Quadraturphasen-Mischer 5 des Quadraturmodulators 3 verbunden ist, und dessen (+)-Eingang der Ausgang des zweiten Differenzverstärkers 27 zugeführt ist. Dem (-)-Eingang des sechsten Differenzverstärkers 31 ist eine vierte Abgleichspannung V_{Q2} zugeführt. Die Abgleichspannungen V_{I1}, V_{Q1}, V_{I2} und V_{Q2} sind in Fig. 1 als steuerbare Spannungsquellen zur besseren Veranschaulichung eingezeichnet, jedoch werden diese Abgleichspannungen zweckmäßigerweise intern in dem digitalen Signalprozessor 2 erzeugt.

Bei der schnellen Umschaltung zwischen Sendebetrieb und Empfangsbetrieb besteht bei Verwendung einer Rückkopplungsschleife 16 nach dem cartesian feedback Prinzip das Problem, daß der Hochfrequenz-Signalpfad der Schleife bestehend aus dem Quadraturmodulator 3, dem Leistungsverstärker 9, dem Quadraturdemodulator 19 und den Differenzverstärkern 26 und 27 beim Umschalten vom Sendebetrieb zum Empfangsbetrieb unterbrochen werden muß, da der Leistungsverstärker 9 und der lokale Oszillator 8 abgeschaltet werden müssen. Bei dem Wiedereinschalten des Leistungsverstärkers 9 und des lokalen Oszillators 8 und dem Wiederherstellen des Hochfrequenz-Signalpfades über die Rückkopplungsschleife 16 kommt es zu einem Schaltstoß, da die Spannungen des Regelsystems, also die Ausgangsspannungen der beiden Differenzverstärker 26, 27 bei geöffneten Hochfrequenz-Signalpfad an den positiven oder negativen Regelanschlag laufen. Dies führt zu einem unzulässigen Leistungssprung auf die maximal mögliche Sendeleistung des Leistungsverstärkers 9. Steht, wie bei der Anwendung beim digitalen Flugfunk VDL (VHF-digital-link), nur ein kurzer Umschaltzeitraum zur Verfügung, so ist das Verfahren des cartesian feedback ohne besondere Maßnahmen nicht anwendbar. Bei einem TDMA-System (wie z. B. VDL) soll die Nachbarkanalleistung durch den Burstbetrieb nicht verschlechtert werden. Die Definition des VDL-Standards ermöglicht theoretisch ein störungsfreies Ein- und Ausschalten der Sendeeinrichtung. Durch die erfindungsgemäße Maßnahme wird ein ideales, störungsfreies Spektrum im getasteten Betrieb gewährleistet.

Die Erfindung schlägt zur Lösung dieses Problems vor, neben dem Hochfrequenz-Signalpfad vom Ausgang der Differenzverstärker 26 und 27 über den Quadraturmodulator 3, den Leistungsverstärker 9 und den Quadraturdemodulator 19 zum (-)-Eingang der Differenzverstärker 26 und 27 zwei direkte Gleichstrom-Signalpfade 32 und 33 vorzusehen, die den Ausgang des jeweils zugeordneten Differenzverstärkers 26 bzw. 27 mit dem (-)-Eingang des jeweiligen Differenzverstärkers 26 bzw. 27 direkt verbinden. Die direkten Gleichstrom-Signalpfade 32 und 33 bestehen im dargestellten Ausführungsbeispiel jeweils aus einem steuerbarem Schalter 34 bzw. 35, die beispielsweise als Feldeffekt-Transistoren ausgebildet sein können, und einem in Serie geschaltetem Widerstand 36 bzw. 37.

Die Umschaltung von dem Sendebetrieb in den Empfangsbetrieb erfolgt erfindungsgemäß so, daß vor dem Öffnen des Hochfrequenz-Signalpfades zunächst die Schalter 34 und 35 geschlossen werden, so daß sowohl der Hochfrequenz-Signalpfad über die Rückkopplungsschleife 16 als auch die direkten Gleichstrom-Signalpfade 32 und 33 in Betrieb ist. Anschließend wird der Umschalter 17 durch den digitalen Signalprozessor 2 so betätigt, daß der Eingang 18 des Quadraturdemodulators 19 nicht mehr mit dem Auskoppler 15 sondern mit dem Abschlußwiderstand 20 verbunden ist und somit der Hochfrequenz-Signalpfad über die Rückkopplungsschleife 16 unterbrochen ist. Da an dem Eingang des Quadraturdemodulators 19 somit kein Eingangssignal mehr anliegt, wird der Pegel an dem (-)-Eingang des ersten und zweiten Differenzverstärkers 26 und 27 über die Rückkopplung des Gleichstrom-Signalpfads 32 bzw. 33 und die konstante Ausgangsspannung der dritten und vierten Differenzverstärkers 28 und 29 bestimmt. Bereits vor dem Öffnen des Hochfrequenz-Signalpfades durch Umschalten des Umschalters 17 kann die Stromversorgung (Bias) des Leistungsverstärkers 9 abgeschaltet werden. Der Sende-Empfangsumschalter 12 an dem Eingang der Antenne 13 kann bereits nach einer Reduzierung des I/Q-Eingangssignals (Ramping) vor dem Betätigen der Schalter 34, 35 und 17 und vor dem Abschalten der Stromversorgung des Leistungsverstärkers 9 umgeschaltet werden, wodurch sofort eine gute Abschaltisolation erreicht wird. Reflektionen, die an dem Sende-Empfangsumschalter 12 auftreten, werden über den Zirkulator 10 dem Abschlußwiderstand 14 zugeführt. Zuletzt wird der lokale Oszillator 8 abgeschaltet.

Beim Umschalten in den Sendebetrieb wird in umgekehrter Reihenfolge vorgegangen:

Zunächst, wird der lokale Oszillator 8 eingeschaltet und die Stromversorgung (Bias) für den Leistungsverstärker 9 zugeschaltet. Anschließend wird der Hochfrequenz-Signalpfad über die Rückkopplungsschleife 16 durch Umschalten des Umschalters 17 geschlossen. Dann werden die Schalter 34 und 35 geöffnet, so daß die Gleichstrom-Signalpfade 32 und 33 wieder unterbrochen werden. Der Sende-Empfangsumschalter 12 wird so geschaltet, daß der Ausgang des Leistungsverstärkers 9 mit der Antenne 13 verbunden ist.

Durch das erfindungsgemäße überlappende Umschalten zwischen Gleichstrom-Signalpfad und Hochfrequenz-Signalpfad wird sichergestellt, daß beim Umschalten keine Signalsprünge auftreten, da der Ausgang des ersten und zweiten Differenzverstärkers 26 bzw. 27 stets entweder über den Hochfrequenz-Signalpfad oder über den Gleichstrom-Signalpfad 32 bzw. 33 mit seinem (-)-Eingang verbunden ist. Somit liegen stets definierte Signalpegel am (-)-Eingang der Differenzverstärker 26 und 27 an.

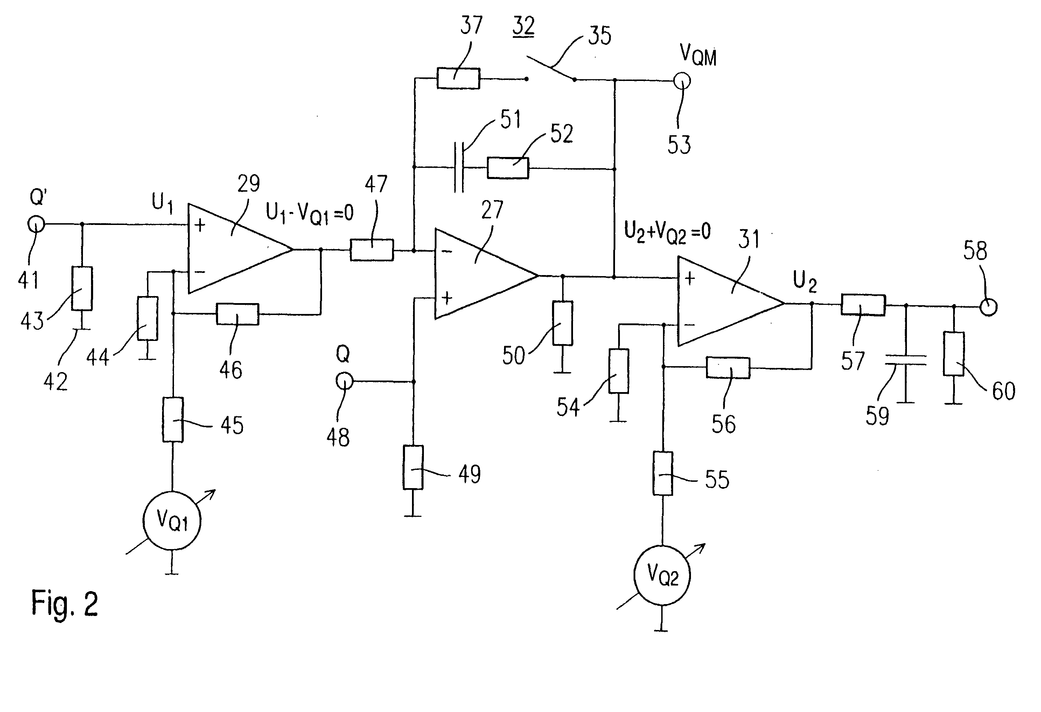

Fig. 2 zeigt die Beschaltung der Differenzverstärker 26, 27,28,29,30 und 31 in einem detaillierterem Schaltbild, wobei lediglich der Signalpfad für die Quadraturphase-Komponente Q, also die Differenzverstärker 29,27 und 31 wiedergegeben ist. Für die Inphase-Komponente I steht eine identische Schaltung zur Verfügung.

Der Eingangsanschluß 41 ist mit dem Ausgang des Quadraturphase-Mischers 23 des Quadraturdemodulators 19 und intern mit dem (+)-Eingang des Differenzverstärkers 29 verbunden. Zwischen dem (+)-Eingang des Differenzverstärkers 29 und der Schaltungsmasse 42 befindet sich ein Widerstand 43. Ein weiterer Widerstand 44 befindet sich zwischen dem (-)-Eingang des Differenzverstärkers 29 und der Schaltungsmasse 42 , wobei dem (-)-Eingang des Differenzverstärkers 29 über einen Serienwiderstand 45 die Abgleichspannung V_{Q1} zugeführt wird. Zwischen dem Ausgang des Differenzverstärkers 29 und seinem (-)-Eingang befindet sich ein weiterer Widerstand 46. Der Ausgang des Differenzverstärkers 29 ist mit dem (-)-Eingang des Differenzverstärkers 27 über einen Serienwiderstand 47 verbunden.

Dem (+)-Eingang des Differenzverstärkers 27 ist die Quadraturphase-Komponente Q des komplexen Eingangssignals über einen Anschluß 48 zugeführt. Zwischen dem Anschluß 48 und der Schaltungsmasse 42 befindet sich ein weiterer Widerstand 49. Ein weiterer Widerstand 50 befindet sich zwischen dem Ausgang des Differenzverstärkers 27 und der Schaltungsmasse 42. Zwischen dem Ausgang des Differenzverstärkers 27 und dem (-)-Eingang des Differenzverstärkers 27 befindet sich ein RC-Glied, bestehend aus dem Kondensator 51 und dem Serienwiderstand 52, welche in Serie geschaltet sind. Parallel dazu befindet sich der Gleichstrom-Signalpfad 33, der aus dem steuerbaren Schalter 35 und dem Serienwiderstand 37 besteht. Durch das Schließen des steuerbaren Schalters 35 wird deshalb ein Potentialausgleich zwischen dem Ausgang des Differenzverstärkers 27 und seinem (-)-Eingang geschaffen. An dem Ausgang des Differenzverstärkers 27 steht an dem Meßpunkt 53 die Meßspannung V_{QM} zur Verfügung, auf deren Bedeutung später noch eingegangen wird.

Die Beschaltung des Differenzverstärkers 31 ist identisch mit der Beschaltung des Differenzverstärkers 29, so daß die Anordnung der Widerstände 54-57 der Anordnung der Widerstände 44-47 entspricht. An dem Ausgangsanschluß 58 kann die Stellgröße für den Quadraturphasen-Mischer 5 des Quadraturmodulators 3 abgenommen werden. An dem Ausgangsanschluß 58 befindet sich ein RC-Glied, bestehend aus dem Kondensator 59 und dem parallel dazu geschalteten Widerstand 60. Das RC-Glied definiert die Bandbreite des Hochfrequenz-Signalpfades.

Das Potential am (+)-Eingang des Differenzverstärkers 29 beträgt U₁, während das Potential am Ausgang des Differenzverstärkers 29 bzw. am (-)-Eingang des Differenzverstärkers 27 U₁-V_{Q1} beträgt. Entsprechend beträgt das Potential am Ausgang des Differenzverstärkers 27 bzw. am (+)-Eingang des Differenzverstärkers 31 U₂+V_{Q2}, so daß sich am Ausgang des Differenzverstärkers 31 ein Potential U₂ einstellt. Die variablen Abgleichspannungen V_{Q1} und V_{Q2} werden durch ein interatives Abgleichverfahren so eingestellt, daß das Potential am (-)-Eingang und am Ausgang des Differenzverstärkers 27 jeweils Null ist, d. h. es gilt U₁-V_{Q1}= 0 und U₂+V_{Q2}=0. Da das Potential am (-)-Eingang und Ausgang des Differenzverstärkers 27 einheitlich Null ist, entstehen bei der Betätigung des Schalters 35 keine Schaltstöße, so daß das Zuschalten und Abschalten des Gleichstrom-Signalpfads 32 stoßfrei erfolgen kann.

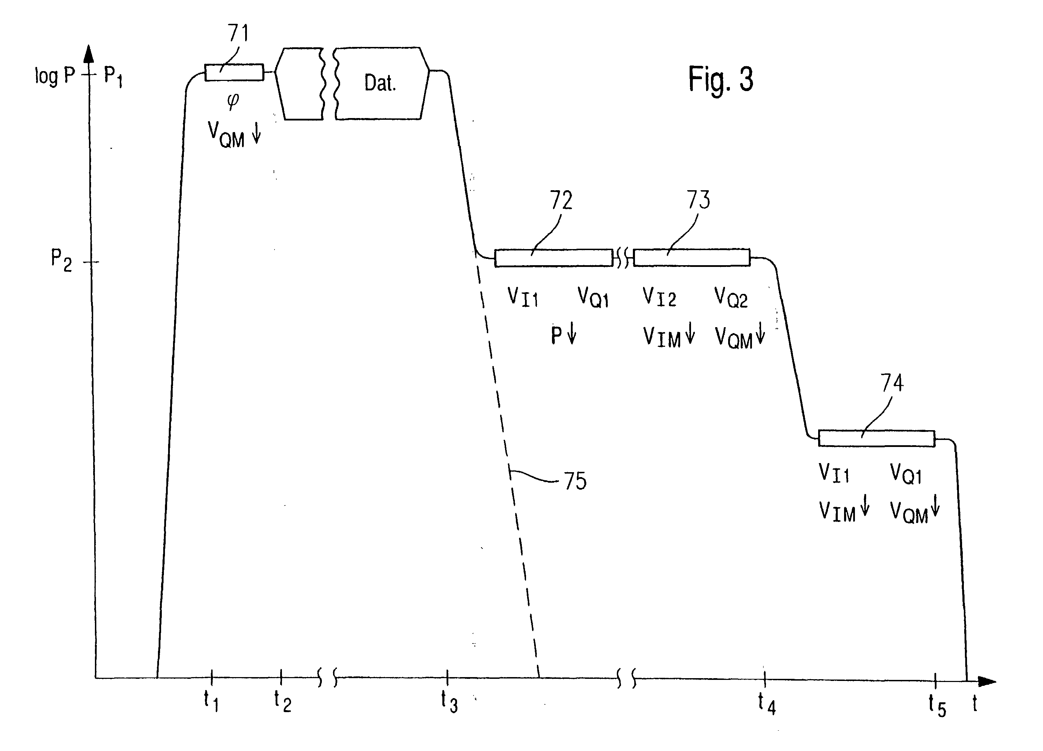

Anhand von Fig. 3 wird das erfindungsgemäße Verfahren zum Umschalten zwischen dem Sendebetrieb und einem Sendeunterbrechungsbetrieb bzw. Empfangsbetrieb erläutert. Gleichzeitig wird anhand dieses schematischen Zeitdiagramms ein erfingungsgemäßes Abgleichverfahren erläutert, das im Rahmen der Erfindung vorteilhaft zum Einsatz kommt. In Fig. 3 ist in einem logarhithmischen Maßstab die Ausgangsleistung P des Leistungsverstärkers 9 als Funktion der Zeit t dargestellt.

Zur Beginn des Sendeintervals ist in dem VDL-Standard vorgeschrieben, daß zunächst für die Dauer von 3 Datensymbolen ein Startsignal übertragen wird, bei welchem das komplexe Eingangssignal ausschließlich eine Inphase-Komponente I jedoch keine Quadraturphase-Komponente Q aufweist. In diesem mit 71 gekennzeichneten Zeitinterval, kann deshalb eine Messung des Phasenwinkels ϕ für den Phasenschieber 25 erfolgen. Da während des Zeitintervals 71 nur eine Inphase-Komponente I übertragen wird, müßte die Spannung an dem Meßpunkt 53 Null sein. Der Phasenwinkel ϕ kann deshalb vor dem nächsten Sendeintervall (burst) gezielt so verändert werden, daß die Meßspannung an dem Meßpunkt 53 auf einen möglichst kleinen Wert optimiert wird. Dieser Phasenwinkel ϕ wird dann bis zum nächsten Sendeinterval aufrecht erhalten und kann im nächsten Sendeinterval weiter optimiert werden.

Zwischen den Zeitpunkten t₂ und t₃ werden Daten übertragen.
Zum Zeitpunkt t₃ ist der eigentliche Sendevorgang beendet. Entsprechend dem VDL-Standard gibt es Situationen, in welcher eine schnelle Umschaltung zwischen dem Sendebetrieb und dem Empfangsbetrieb innerhalb von einigen 100 µs erfolgen muß. Dies ist durch die Linie 75 in Fig. 3 angedeutet. In diesem Fall wird wie vorstehend beschrieben vorgegangen: es wird der Sende-Empfangsumschalter 12 umgeschaltet und es werden durch Schließen der Schalter 34 und 35 zunächst die Gleichstrom-Signalpfade 32 und 33 hergestellt. Anschließend wird die Stromversorgung (Bias) des Leistungsverstärkers 9 abgeschaltet und der Eingang 18 des Quadraturdemodulators 19 von dem Auskoppler 15 auf den Abschlußwiderstand 20 umgeschaltet. Schließlich wird der lokale Oszillator 8 abgeschaltet.

Es gibt jedoch im VDL-Betrieb auch Situationen, die eine langsamere Umschaltung zwischen dem Sendebetrieb und dem Empfangsbetrieb ermöglichen, wobei ca. 2,5 ms für einen automatischen Abgleich zur Verfügung stehen. Dieser automatische Abgleich wird nachfolgend beschrieben.

In einem optionalen Feinabgleich während des Zeitintervals 72 wird ein Feinabgleich des Quadraturdemodulators 19 vorgenommen. Dieser Feinabgleich kann gegebenenfalls auch entfallen. Hierfür wird zunächst das Eingangssignal I/Q auf Null heruntergeregelt, so daß der Leistungsverstärker nur noch eine minimale Restleistung P2 erzeugt. Die Abgleichspannungen V_{I1} und V_{Q1} , die den Gleichspannungsversatz des Quadraturdemodulators 19 kompensieren, werden so optimiert, daß an dem logarithmischen Leistungsdetektor 39 eine minimale Restleistung P₂ detektiert wird. Da kein Eingangssignal I/Q anliegt, ist die ideale Ausgangsleistung P₂ Null und ein bestehendes Ausgangssignal rührt im wesentlichen von dem Gleichspannungsversatz des Quadraturdemodulators 19 her.

In dem nachfolgenden Zeitinterval 73 erfolgt ein Abgleich des Quadraturmodulators 3, indem die Meßspannung V_{IM} der Inphase-Komponente an dem Meßpunkt 61 und die Meßspannung V_{QM} der Quadraturphase-Komponenete an dem Meßpunkt 53 in Fig. 1 gemessen werden. Auch bei dieser Messung ist sowohl die Inphase-Komponente I als auch die Quadraturphase-Komponente Q des von dem digitalen Signalprozessors 2 erzeugten Eingangssignals Null, so daß die gemessene Spannung V_{QM} im wesentlichen von dem Gleichspannungsversatz des Quadraturmodulators 3 herrührt. Durch Ableich der Spannungen V_{I2} und V_{Q2} werden die Meßspannungen V_{IM} und V_{QM} gegen Null minimiert. Dadurch wird der Gleichspannungsversatz des Modulators 3 kompensiert.

Die Messung im Zeitinterval 72 und 73 erfolgt bei noch geschlossenem Hochfrequenz-Signalpfad, d. h. die Schalter 34 und 35 sind noch geöffnet und der Schalter 17 verbindet den Eingang 18 des Quadraturdemodulators 19 mit dem Auskoppler 15. Ferner ist die Spannungsversorgung (Bias) für den Leistungsverstätker 9 noch angeschaltet.

Im Zeitpunkt t₄ werden zunächst die beiden Schalter 34 und 35 geschlossen und nachfolgend der Umschalter 17 auf den Abschlußwiderstand 20 umgeschaltet, so daß nunmehr die Gleichstrom-Signalpfade 32 und 33, jedoch nicht der Hochfrequenz-Signalpfad, aktiv sind. Vor dem Betätigen des Umschalters 17 wird die Stromversorgung des Leistungsverstärkers 9 abgeschaltet.

Da folglich das Eingangssignal an dem Quadraturdemodulator 19 Null ist und weiterhin das von dem digitalem Signalprozessor 2 erzeugte Eingangssignal I,Q Null ist, wird eine an den Meßpunkten 53 und 61 gemessene Meßspannung V_{IM} und V_{QM} im wesentlichen von dem Gleichspannungsversatz des Quadraturdemodulators 19 verursacht. Durch Verstellen der Abgleichspannungen V_{I1} und V_{Q1} im Zeitintervall 74 kann dieser Gleichspannungsversatz und somit die Meßspannung V_{IM} bzw. V_{QM} minimiert werden. Die durch diese Abgleichprozedur gefundenen Werte für die Abgleichspannungen V_{I1}, V_{Q1}, V_{I2}, V_{Q2} können für das nächste Sendeinterval verwendet werden.

Im Zeitpunkt t₅ wird der Pegel des lokalen Oszillators 8 zusätzlich abgeschaltet, um eine Einstrahlung in den Empfänger zu vermeiden. Dadurch wird die Isolation zwischen dem Sender und dem Empfänger weiter erhöht.

Die Erfindung ist nicht auf das dargestellte Ausführungsbeispiel beschränkt. Insbesondere können die Abgleichschritte auch in anderer Reihenfolge vorgenommen werden oder einzelne Abgleichschritte können entfallen.

## Patentansprüche

1. Sendeeinrichtung (1) mit
einem Quadraturmodulator (3) zur Quadraturmodulation einer Inphase-Komponente (I) und einer Quadraturphase-Komponente (Q) eines komplexen Eingangssignals (I,Q),
einem dem Quadraturmodulator (3) nachgeschalteten Leistungsverstärker (9),
einem Quadraturdemodulator (19) zur Quadraturdemodulation des Ausgangssignals des Leistungsverstärkers (9) in eine rückgekoppelte Inphase-Komponente (I') und eine rückgekoppelte Quadraturphase-Komponente (Q'),
einem dem Quadraturmodulator (3) vorgeschalteten ersten Differenzverstärker (26), dessen ersten Eingang (+) die Inphase-Komponente (I) des Eingangssignals und dessen zweiten Eingang (-) die rückgekoppelte Inphase-Komponente (I') zugeführt ist, und
einem dem Quadraturmodulator (3) vorgeschalteten zweiten Differenzverstärker (27), dessen ersten Eingang (+) die Quadraturphase-Komponente (Q) des Eingangssignals und dessen zweiten Eingang (-) die rückgekoppelte Quadraturphase-Komponente (Q') zugeführt ist,
**gekennzeichnet durch** Mittel zumdirekten Verbinden des Ausgangs des ersten und zweiten Differenzverstärkers (26,27) über jeweils einen direkten Gleichstrom-Signalpfad (32,33) unter Umgehung des Quadraturmodulators (3), des Leistungsverstärkers (8) und des Quadraturdemodulators (19) mit dem zweiten Eingang (-) des jeweiligen Differenzverstärkers (26,27) beim Umschalten von einem Sendebetrieb in einen Sendeunterbrechungsbetrieb.

2. Sendeeinrichtung nach Anspruch 1,
**dadurch gekennzeichnet,**
**daß** der direkte Gleichstrom-Signalpfad (32,33) jeweils einen ersten steuerbaren Schalter (34,35) aufweist.

3. Sendeeinrichtung nach Anspruch 2,
**dadurch gekennzeichnet,**
**daß** das Signal der rückgekoppelten Inphase-Komponente (I') und der rückgekoppelten Quadraturphase-Komponente (Q') mittels eines zweiten steuerbaren Schalters (17) unterbrechbar ist.

4. Sendeeinrichtung nach Anspruch 3,
**dadurch gekennzeichnet,**
**daß** sich der zweite steuerbare Schalter (17) am Eingang des Quadraturdemodulators (19) befindet und bei einer Signalunterbrechung den Eingang des Quadraturdemodulator (19) über einen definierten Eingangswiderstand (20) abschließt.

5. Sendeeinrichtung nach Anspruch 4,
**gekennzeichnet durch** Mittel zum Abgleichen eines Gleichspannungsversatzes der Inphase-Komponente (I') des Quadraturdemodulators (19) mittels einer ersten Abgleichspannung (V_{I1}) und eines Gleichspannungsversatzes der Quadraturphase-Komponente (Q') des Quadraturdemodulators (19) mittels einer zweiten Abgleichspannung (V_{Q1}).

6. Sendeeinrichtung nach Anspruch 5,
**dadurch gekennzeichnet,**
**daß** dem ersten Differenzverstärker (26) ein dritter Differenzverstärker (28) vorgeschaltet ist, mit welchem die erste Abgleichspannung (V_{I1}) verbunden ist, und dem zweiten Differenzverstärker (27) ein vierter Differenzverstärker (29) vorgeschaltet ist, mit welchem die zweite Abgleichspannung (V_{Q1}) verbunden ist.

7. Sendeeinrichtung nach Anspruch 5 oder 6,
**gekennzeichnet durch** Mittel zum Abgleichen eines Gleichspannungsversatzes der Inphase-Komponente (I) des Quadraturmodulators (3) mittels einer dritten Abgleichspannung (V_{I2}) und eines Gleichspannungsversatzes der Quadraturphase-Komponente (Q) des Quadraturmodulators (3) mittels einer vierten Abgleichspannung (V_{Q2}).

8. Sendeeinrichtung nach Anspruch 7, **dadurch gekennzeichnet,**
**daß** dem ersten Differenzverstärker (26) ein fünfter Differenzverstärker (30) nachgeschaltet ist, mit welchem die dritte Abgleichspannung (V_{I2}) verbunden ist, und dem zweiten Differenzverstärker (27) ein sechster Differenzverstärker (31) nachgeschaltet ist, mit welchem die vierte Abgleichspannung (V_{Q2}) verbunden ist.

9. Verfahren zum Umschalten einer Sendeeinrichtung (1) mit einem Quadraturmodulator (3) zur Quadraturmodulation einer Inphase-Komponente (I) und einer Quadraturphase-Komponente (Q) eines komplexen Eingangssignals (I,Q),
einem dem Quadraturmodulator (3) nachgeschalteten Leistungsverstärker (9),
einem Quadraturdemodulator (19) zur Quadraturdemodulation des Ausgangssignals des Leistungsverstärkers (9) in eine rückgekoppelte Inphase-Komponente (I') und eine rückgekoppelte Quadraturphase-Komponente (Q'),
einem dem Quadraturmodulator (3) vorgeschalteten ersten Differenzverstärker (26), dessen ersten Eingang (+) die Inphase-Komponente (I) des Eingangssignals und dessen zweiten Eingang (-) die rückgekoppelte Inphase-Komponente (I') zugeführt wird, und einem dem Quadraturmodulator (3) vorgeschalteten zweiten Differenzverstärker (27), dessen ersten Eingang (+) die Quadraturphase-Komponente (Q) des Eingangssignals und dessen zweiten Eingang (-) die rückgekoppelte Quadraturphase-Komponente (Q') zugeführt wird,
von einem Sendebetrieb in einen Sendeunterbrechungsbetrieb, **gekennzeichnet durch** folgende Verfahrensschritte:
- Zuschalten jeweils eines Gleichstrom-Signalpfades (32,33) zwischen dem Ausgang und dem zweiten Eingang (-) des ersten und zweiten Differenzverstärkers (26,27) vor dem
- Öffnen eines Hochfrequenz-Signalpfades (16), welcher vom Ausgang des ersten und zweiten Differenzverstärkers (26,27) über den Quadraturmodulator (3), den Leistungsverstärker (9) und den Quadraturdemodulator (19) zum zweiten Eingang (-). des ersten und zweiten Differenzverstärkers (26,27) führt.

10. Verfahren nach Anspruch 9,
**gekennzeichnet durch,**
folgende Verfahrensschritte beim Umschalten vom Sendebetrieb in den Sendeunterbrechungsbetrieb:
- Zuschalten des Gleichstrom-Signalpfades (32,33),
- Abschalten einer Spannungsversorgung für den Leistungsverstärker (49) und
- Öffnen des Hochfrequenz-Signalpfades vor dem Eingang (18) des Quadraturdemodulators (19) und Abschließen des Eingangs (18) des Quadraturdemodulators (19) mit einem definierten Eingangswiderstand (20).

## Claims

1. Transmitter (1) with
a quadrature modulator (3) for quadrature modulating an in-phase component (I) and a quadrature phase component (Q) of a complex input signal (I, Q),
a power amplifier (9) connected downstream of the quadrature modulator (3),
a quadrature demodulator (19) for quadrature demodulating the output signal of the power amplifier (9) into a feedback in-phase component (I') and a feedback quadrature phase component (Q'),
a first differential amplifier (26) connected upstream of the quadrature modulator (3), to the first input (+) of which the in-phase component (I) of the input signal is applied and to the second input (-) of which the feedback in-phase component (I') is applied, and a second differential amplifier (27) connected upstream of the quadrature modulator (3), to the first input (+) of which the quadrature-phase component (Q) of the input signal is applied and to the second input (-) of which the feedback quadrature-phase component (Q') is applied,
**characterised by** means for directly connecting the output of the first and second differential amplifiers (26, 27) to the second input (-) of the respective differential amplifier (26, 27) respectively via a direct DC signal path (32, 33), bypassing the quadrature modulator (3), the power amplifier (8) and the quadrature modulator (19) when switching from a transmission mode to a transmission-interrupt mode.

2. Transmitter as claimed in claim 1,
**characterised in that**
each direct DC signal path (32, 33) has a respective first controllable switch (34, 35).

3. Transmitter as claimed in claim 2,
**characterised in that**
the signal of the feedback in-phase component (I') and the feedback quadrature-phase component (Q') can be interrupted by means of a second controllable switch (17).

4. Transmitter as claimed in claim 3,
**characterised in that**
the second controllable switch (17) is disposed at the input of the quadrature demodulator (19) and deactivates the input of the quadrature demodulator (19) via a defined input resistance (20) in the event of a signal interruption.

5. Transmitter as claimed in claim 4,
**characterised by** means for compensating a DC offset of the in-phase component (I') of the quadrature demodulator (19) by means of a first compensating voltage (V_{I1}) and a DC offset of the quadrature-phase component (Q') of the quadrature demodulator (19) by means of a second compensating voltage (V_{Q1}).

6. Transmitter as claimed in claim 5,
**characterised in that**
a third differential amplifier (28) is connected upstream of the first differential amplifier (26), to which the first compensating voltage (V_{I1}) is connected, and a fourth differential amplifier (29) is connected upstream of the second differential amplifier (27), to which the second compensating voltage (V_{Q1}) is connected.

7. Transmitter as claimed in claim 5 or 6,
**characterised by** means for compensating a DC offset of the in-phase component (I) of the quadrature modulator (3) by means of a third compensating voltage (V_{I2}) and a DC offset of the quadrature-phase component (Q) of the quadrature modulator (3) by means of a fourth compensating voltage (V_{Q2}).

8. Transmitter as claimed in claim 7,
**characterised in that**
a fifth differential amplifier (30) is connected downstream of the first differential amplifier (26), to which the third compensating voltage (V_{I2}) is connected, and a sixth differential amplifier (31) is connected downstream of the second differential amplifier (27), to which the fourth compensating voltage (V_{Q2}) is connected.

9. Method of switching a transmitter (1) having a quadrature modulator (3) for quadrature modulating an in-phase component (I) and a quadrature-phase component (Q) of a complex input signal (I,Q),
a power amplifier (9) connected downstream of the quadrature modulator (3),
a quadrature demodulator (19) for quadrature demodulating the output signal of the power amplifier (9) into a feedback in-phase component (I') and a feedback quadrature-phase component (Q'),
a first differential amplifier (26) connected upstream of the quadrature modulator (3), to the first input (+) of which the in-phase component (I) of the input signal is applied and to the second input (-) of which the feedback in-phase component (I') is applied, and
a second differential amplifier (27) connected upstream of the quadrature modulator (3), to the first input (+) of which the quadrature-phase component (Q) of the input signal is applied and to the second input (-) of which the feedback quadrature-phase component (Q') is applied,
from a transmission mode into a transmission-interrupt mode,
**characterised by**
the following method steps:
- activating a DC signal path (32,33) between the output and the second input (-) of the first and second differential amplifiers (26, 27) respectively prior to
- opening a high-frequency signal path (16), leading from the output of the first and second differential amplifier (26,27) via the quadrature modulator (3), power amplifier (9) and quadrature modulator (19) to the second input (-) of the first and second differential amplifiers (26, 27).

10. Method as claimed in claim 9,
**characterised by**
the following method steps when switching from transmission mode to transmission-interrupt mode:
- activating the DC Signal path (32, 33),
- de-activating a voltage supply for the power amplifier (49) and
- opening the high-frequency signal path upstream of the input (18) of the quadrature demodulator (19) and closing the input (18) of the quadrature demodulator (19) with a defined input resistance (20).

## Revendications

1. Emetteur (1) comprenant
un modulateur en quadrature (3) pour la modulation en quadrature d'une composante en phase (I) et une composante de phase en quadrature (Q) d'un signal d'entrée (I, Q) complexe,
un amplificateur de puissance (9) monté en aval du modulateur en quadrature (3),
un démodulateur en quadrature (19) pour la démodulation en quadrature du signal de sortie de l'amplificateur de puissance (9) en une composante en phase (I') réinjectée et une composante de quadrature en phase (Q') réinjectée,
un premier amplificateur différentiel (26) monté en amont du modulateur en quadrature (3), à la première entrée (+) duquel est amenée la composante en phase (I) du signal d'entrée et à la seconde entrée (-) duquel est amenée la composante en phase (I') réinjectée,
et un second amplificateur différentiel (27) monté en amont du modulateur en quadrature (3), à la première entrée (+) duquel est amenée la composante de phase en quadrature (Q) du signal d'entrée et à la seconde entrée (-) duquel est amenée la composante de phase en quadrature (Q') réinjectée,
**caractérisé par** des moyens pour la liaison directe de la sortie des premier et second amplificateurs différentiels (26, 27) au moyen de respectivement un cheminement direct de signal à courant continu (32, 33) en contournant le modulateur en quadrature (3), l'amplificateur de puissance (8) et le démodulateur en quadrature (19) avec la seconde entrée (-) de l'amplificateur différentiel (26, 27) respectif lors de la commutation d'un mode d'émission en un mode d'interruption d'émission.

2. Emetteur selon la revendication 1, **caractérisé en ce que** le cheminement direct de signal à courant continu (32, 33) présente respectivement un premier interrupteur (34, 35) contrôlable.

3. Emetteur selon la revendication 2, **caractérisé en ce que** le signal de la composante en phase (I') réinjectée et de la composante de phase en quadrature (Q') réinjectée peut être interrompu au moyen d'un second interrupteur (17) contrôlable.

4. Emetteur selon la revendication 3,
**caractérisé en ce que**,
le second interrupteur (17) contrôlable se trouve à l'entrée du démodulateur en quadrature (19) et ferme l'entrée du démodulateur en quadrature (19) lors d'une interruption du signal au moyen d'une résistance d'entrée (20) définie ;

5. Emetteur selon la revendication 4,
**caractérisé par** des moyens pour le réglage d'un déport de tension continue (15) de la composante en phase (I') du démodulateur en quadrature (19) au moyen d'une première tension de réglage (V_{I1}) et d'un déport de tension continue 5 de la composante de phase en quadrature (Q') du démodulateur en quadrature (19) au moyen d'une seconde tension de réglage (V_{Q1}).

6. Emetteur selon la revendication 5,
**caractérisé en ce que**
en aval du premier amplificateur différentiel (26) est monté un troisième amplificateur différentiel (28), avec lequel la première tension de réglage (V_{I1}) est reliée, et en amont du second amplificateur différentiel (27) est monté un quatrième amplificateur différentiel (29), avec lequel la seconde tension de réglage (V_{Q1}) est reliée.

7. Emetteur selon la revendication 5 ou 6,
**caractérisé par** des moyens pour le réglage d'un déport de tension continue 25 de la composante en phase (I) du modulateur en quadrature (3) au moyen d'une troisième tension de réglage (V_{I2}) et d'un déport de tension continue de la composante de phase en quadrature (Q) du modulateur en quadrature (3) au moyen d'une quatrième tension de réglage (V_{Q2}).

8. Emetteur selon la revendication 7,
**caractérisé en ce qu'**en aval du premier amplificateur différentiel (26) est monté un cinquième amplificateur différentiel (30), avec lequel la troisième tension de réglage (V_{I2}) est reliée, et en aval du second amplificateur différentiel (27) est monté un sixième amplificateur différentiel (31), avec lequel la quatrième tension de réglage (V_{Q2}) est reliée.

9. Procédé pour la commutation d'un émetteur (1) avec un modulateur en quadrature (3) pour la modulation en quadrature d'une composante en phase (I) et d'une composante de phase en quadrature (Q) d'un signal d'entrée (I, Q) complexe,
un amplificateur de puissance (9) monté en aval du modulateur en quadrature (3), un démodulateur en quadrature (19) pour la démodulation en quadrature du signal de sortie de l'amplificateur de puissance (9) en une composante en phase (I') réinjecté et une composante de phase en quadrature (Q') réinjectée,
un premier amplificateur différentiel (26) monté en amont du modulateur en quadrature (3), à la première entrée (+) duquel est amenée la composante en phase (I) du signal d'entrée et à la seconde entrée (-) duquel est amenée la composante en phase (I') réinjectée,
un second amplificateur différentiel (27) monté en amont du modulateur en quadrature (3), à la première entrée (+) duquel est amenée la composante de phase en quadrature (Q) du signal d'entrée et à la seconde entrée (-) duquel est amenée la composante de phase en quadrature (Q') réinjectée, d'un mode émission en un mode interruption d'émission, **caractérisé par** les étapes de procédé suivantes :
- mise en circuit de respectivement un cheminement de signal à courant continu (32, 33) entre la sortie et la seconde entrée (-) du premier et du second amplificateurs différentiels (26, 27) avant
- l'ouverture d'un cheminement de signal à haute fréquence (16), qui va de la sortie du premier et du second -amplificateurs différentiels (26, 27) via le modulateur en quadrature (3), l'amplificateur de puissance (9) et le démodulateur en quadrature (19) à la seconde entrée (-) du premier et du second amplificateurs différentiels (26, 27).

10. Procédé selon la revendication 9,
**caractérisé par** les étapes de procédé suivantes lors de la commutation du mode émission dans le mode interruption d'émission :
- mise en circuit du cheminement de signal à courant continu (32, 33)
- mise hors circuit d'une alimentation de tension pour l'amplificateur de puissance (49)
- ouverture du cheminement de signal à haute fréquence avant l'entrée (18) du démodulateur en quadrature (19) et fermeture de l'entrée (18) du démodulateur en quadrature (19) avec une résistance d'entrée (20) définie.
